# EUROPEAN PATENT APPLICATION

(11) **EP 4 836 669 A1**
(43) Date of publication of application: **04.11.2026**
(21) Application number: 26172775.4
(22) Date of filing: 16.04.2026
(51) Int. Cl.: H10W 40/25, H10W 40/20, H10W 40/22, H10W 70/60

(54) **FLIP CHIP PACKAGE WITH COMPLIANT HEAT SPREADER**

(30) Priority: 29.04.2025 US 202519192742
(71) Applicant: STMicroelectronics International N.V., 1228 Plan-les-Ouates, Geneva (CH)
(72) Inventor: TALLEDO, Jefferson Sismundo, 4027 CALAMBA - LAGUNA (PH)
(74) Representative: Cabinet Beaumont

(57) **Abstract**

A substrate has a front surface with front connection pads. An integrated circuit die, having a front surface with die connection pads and rear surface, is mounted to the substrate in a flip chip orientation with the front surface of the integrated circuit die facing the front surface of the substrate. The die connection pads are electrically connected to the front connection pads. A thermally conductive cap is mounted to the substrate to enclose the integrated circuit die. A compliant heat spreader is positioned between the rear surface of the integrated circuit die and an inside surface of the thermally conductive cap. The compliant heat spreader is made of a porous metal foam material layer having pores which contain a thermal interface material.

## Description

### TECHNICAL FIELD

The present disclosure generally relates to integrated circuit packaging and, in particular, to the packaging of a flip chip integrated circuit die with a compliant heat spreader.

### BACKGROUND

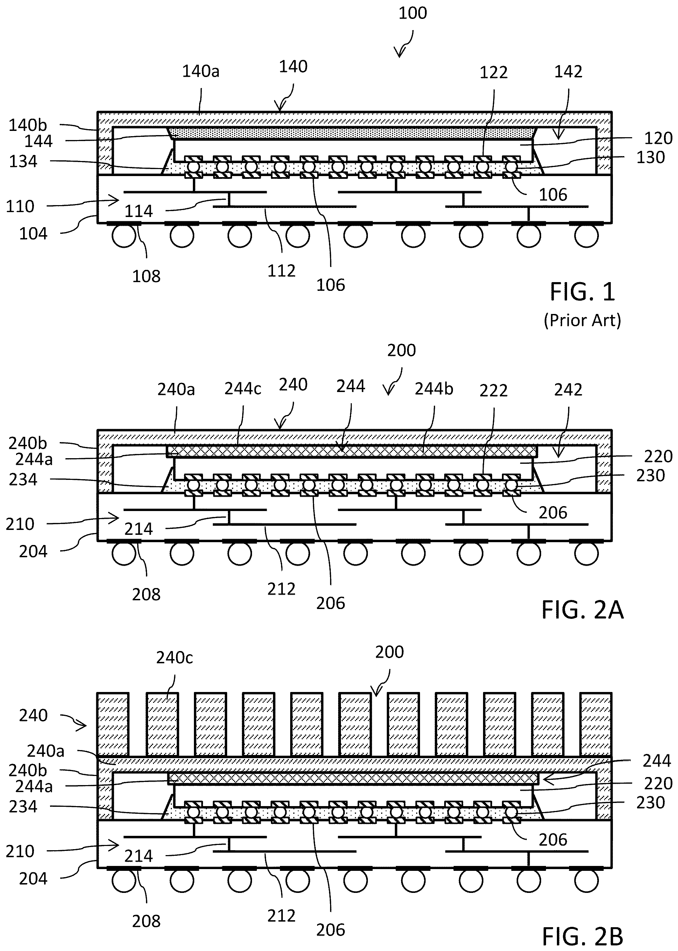

Reference is made to Figure 1 which shows a cross-sectional view of an integrated circuit package 100. The package 100 includes a substrate 104 formed, for example, by an organic build-up substrate or ceramic substrate including front connection pads 106 on a front surface, rear connection pads 108 (for example, forming a ball grid array (BGA) structure) on a back surface and an electrical connection network 110 (the full details of which are not explicitly illustrated as the structure and layout of such an electrical connection network with connection lines 112 and connection vias 114 is application dependent and well-known to those skilled in the art) for electrically connecting the front connection pads 106 to the rear connection pads 108.

An integrated circuit (IC) die 120 has opposed front and rear surfaces. The front surface includes a plurality of die connection pads 122. In a common implementation, the die 120 includes a semiconductor layer covered by an interconnection layer, where the die connection pads 122 are provided at an upper surface of the interconnection and connected by lines and vias of the interconnection layer to integrated circuit structures supported in and on top of the semiconductor layer. The die 120 is mounted to the substrate 104 in what is referred to in the art as a "flip chip" orientation, where front surface of the die faces the front surface of the substrate. The die connection pads 122 of the die 120 are electrically connected to the front connection pads 106 using electrical connection structures 130 in the form of conductive balls or pillars. To further mechanically secure the die 120 to the substrate 104, an underfill epoxy 134 is provided between the front surface of the die and the front surface of the substrate and encapsulating the electrical connection structures 130.

A heat spreader cap (or lid) 140, for example made of a thermally conductive material such as Copper, is mounted to the substrate 104 to enclose the die 120 within a chamber 142. The cap 140 includes a front wall 140a and a peripheral sidewall 140b defining the chamber 142, with a distal end of the peripheral sidewall 140b attached to the front surface of the substrate using a layer of suitable thermally and/or electrically conductive adhesive material (not explicitly shown). A layer of thermal interface material (TIM) 144 is positioned between the rear surface of the die 120 and the inside surface of the cap 140.

A number of concerns exist with respect to the flip chip package shown in Figure 1: the cap 140 may not provide sufficient power dissipation; dissipation can be adversely impacted by any tilting of the cap 140 and/or anomalies in the thermal interface material 144; and temperature change during operation can induce a warping of the cap 140 which causes a break in contact (i.e., an interface gap) between the thermal interface material 144 and the inside surface of the cap 140.

There is a need in the art to address the foregoing concerns.

There is a need in the art for improved packaging of an integrated circuit die mounted in a flip chip orientation.

### SUMMARY

In an embodiment, an integrated circuit package comprises: a substrate having a front surface with front connection pads; an integrated circuit die having a front surface and rear surface with die connection pads at the front surface; wherein the integrated circuit die is mounted to the substrate in a flip chip orientation with the front surface of the integrated circuit die facing the front surface of the substrate; electrical connections between the die connection pads and the front connection pads; a thermally conductive cap mounted to the substrate to enclose the integrated circuit die; and a compliant heat spreader positioned between the rear surface of the integrated circuit die and an inside surface of the thermally conductive cap, wherein the compliant heat spreader comprises a porous metal foam material layer with a thermal interface material contained within pores of the porous metal foam material layer.

In an embodiment, a method of making an integrated circuit package comprises: mounting an integrated circuit die in flip chip orientation to a substrate; mounting a porous metal foam material layer to an inside surface of a thermally conductive cap; placing a thermal interface material within pores of the porous metal foam material layer; and attaching the thermally conductive cap to the substrate to enclose the integrated circuit die with porous metal foam material layer positioned in contact with a back surface of the integrated circuit die.

### BRIEF DESCRIPTION OF THE DRAWINGS

For a better understanding of the embodiments, reference will now be made by way of example only to the accompanying figures in which:
Figure 1 is a cross-sectional view of a conventional integrated circuit package for a flip chip oriented integrated circuit die;
Figures 2A, 2B, 3 and 4 are cross-sectional views of an integrated circuit package for a flip chip oriented integrated circuit die; and
Figure 5 is a flow diagram for a method of making the package.

### DETAILED DESCRIPTION

In the following description, certain specific details are set forth in order to provide a thorough understanding of various aspects of the disclosed subject matter. However, the disclosed subject matter may be practiced without these specific details. In some instances, well-known structures and methods of semiconductor processing comprising embodiments of the subject matter disclosed herein have not been described in detail to avoid obscuring the descriptions of other aspects of the present disclosure.

Reference is made to Figures 2A and 2B which show cross-sectional views of an integrated circuit package 200. The package 200 includes a substrate 204 formed, for example, by an organic build-up substrate or ceramic substrate including front connection pads 206 at a front surface, rear connection pads 208 (for example, forming a ball grid array (BGA) structure) at a rear surface and an electrical connection network 210 (the full details of which are not explicitly illustrated as the structure and layout of such an electrical connection network with connection lines 212 and connection vias 214 is application dependent and well-known to those skilled in the art) for electrically connecting the front connection pads 206 to the rear connection pads 208.

An integrated circuit (IC) die 220 has opposed front and rear surfaces. The front surface includes a plurality of die connection pads 222. In a common implementation, the die 220 includes a semiconductor layer covered by an interconnection layer, where the die connection pads 222 are provided at an upper surface of the interconnection and connected by lines and vias of the interconnection layer to integrated circuit structures supported in and on top of the semiconductor layer. The die 220 is mounted to the substrate 204 in what is referred to in the art as a "flip chip" orientation, where front surface of the die faces the front surface of the substrate. The die connection pads 222 of the die 220 are electrically connected to the front connection pads 206 using electrical connection structures 230 in the form of conductive balls or pillars. To further mechanically secure the die 220 to the substrate 204, an underfill epoxy 234 is provided between the front surface of the die and the front surface of the substrate and encapsulating the electrical connection structures 230.

A heat spreader cap (or lid) 240, for example made of a thermally conductive material such as Copper, is mounted to the substrate 204 to enclose the die 220 within a chamber 242. The cap 240 includes a front wall 240a and a peripheral sidewall 240b defining the chamber 242, with a distal end of the peripheral sidewall 240b attached to the front surface of the substrate using a layer of suitable thermally and/or electrically conductive adhesive material (not explicitly shown). In Figure 2B, the cap further includes heat spreading fins 240c extending from the front wall 240a. A compliant heat spreader 244 is positioned between the rear surface of the die 220 and the inside surface of the cap 240. This compliant heat spreader 244 comprises a layer 244a of porous metal foam material, for example made of Copper, having pores (or interstices) 244b that contain a thermal interface material (TIM). The compliant heat spreader 244 is positioned between the rear surface of the die 220 and the inside surface of the cap 240.

In a preferred implementation, the thermal interface material substantially (i.e., to a level in excess of 90%), more preferably completely, fills the pores 244b. In an implementation, the thermal interface material may be considered to saturate the porous metal foam material.

In a preferred implementation, the porous metal foam material of layer 244a is secured to the inside surface of the cap 240 using an attachment layer 244c formed by diffusion welding or brazing.

In a preferred implementation, the porous metal foam material of layer 244a has a relatively lower modulus suitable to provide a material layer that is compliant and springy. In this way, the layer 244a may deform (through expansion or compression) so as to compensate for warpage of the cap 240 and prevent the formation of an interface gap that would impede power dissipation. The deformation of the layer 244a would conform to deformation in the cap 240.

In a preferred implementation, a porosity of the porous metal foam material of layer 244a is selected to ensure deformation compliance.

In an embodiment, the porous metal foam material of layer 244a may have a porosity of 80%. Thus, the compliant heat spreader 244 effectively has a volume which is 20% metal (such as Copper) and 80% thermal interface material.

In an embodiment, the compliant heat spreader 244 formed by layer 244a with embedded thermal interface material may be characterized as follows: an effective coefficient of thermal expansion in a range of 3 to 30 ppm/°C (for example, about 13 ppm/°C); an effective E-modulus in a range of 1 to 40 GPa (for example, about 23.74 GPa); an effective Poisson's ratio in a range of 0.25 to 0.35 (for example, about 0.30); and an effective thermal conductivity in a range of 10 to 200 W/m-K (for example, about 83.35 W/m-K). In this context, the Copper of the layer 244a would have a thermal conductivity of 401 W/m-K and an E-modulus of 117 GPa, while the thermal interface material would have a thermal conductivity of 3.94 W/m-K and an E-modulus of 0.421 GPa. The compliant heat spreader 244 has a junction-to-case thermal resistance (Rjc) in a range of 0.30 to 0.50 °C/W (for example, about 0.43 °C/W).

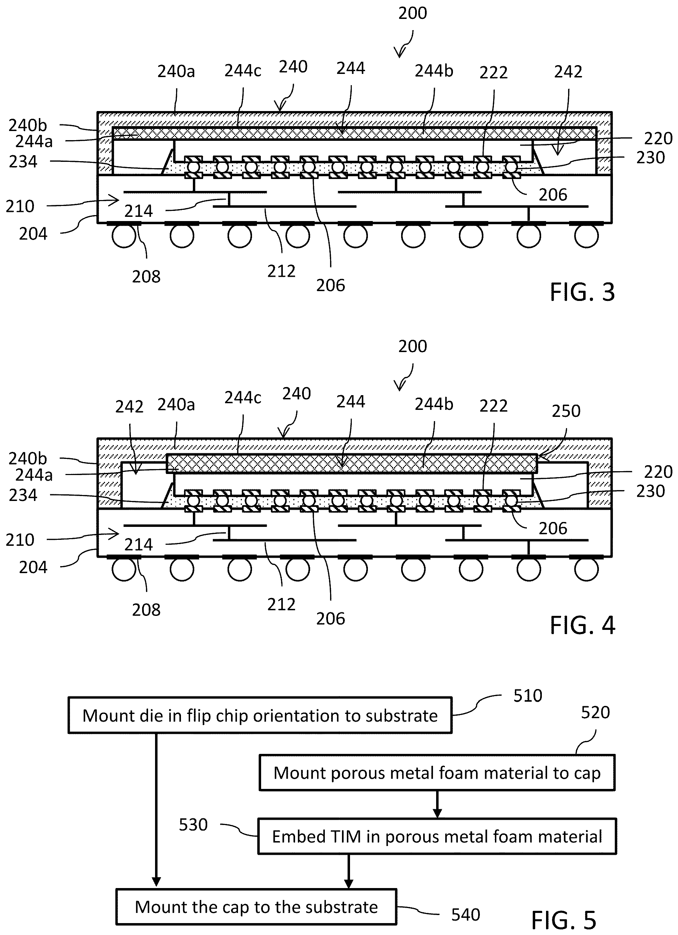

Figure 3 shows an alternative implementation where the layer 244a extends on the inside surface of the cap 240 fully across the breadth (width and length) of the chamber 242. In other words, the area occupied by the layer 244a is the same as the area of the inside surface of the cap 240 at the front wall 240a. The implementation of Figures 2A and 2B, on the other hand, shows that the layer 244a has an area which generally conforms to, but is slightly larger than, the area of the rear surface of the die 220 but is less than the area of the inside surface of the cap 240 at the front wall 240a.

Figure 4 shows an alternative implementation where the layer 244 is contained within a recess 250 provided in the inside surface of the cap 240 at the front wall 240a. The recess 250, within which the layer 244a is positioned, has an area which generally conforms to, but is slightly larger than, the area of the rear surface of the die 220 but is less than the area of the inside surface of the cap 240 at the front wall 240a.

Reference is now made to Figure 5 which shows a flow diagram for a process of making the package 200. In step 510, the integrated circuit die 220 is mounted in flip chip orientation to the substrate 210. This mounting includes electrically connecting the die connection pads 222 of the die 220 to the front connection pads 206 using electrical connection structures 230 in the form of conductive balls or pillars, and securing the die to the substrate using the underfill epoxy 234 between the front surface of the die and the front surface of the substrate and encapsulating the electrical connection structures 230. In step 520, the porous metal foam material of layer 244a is mounted by diffusion welding or brazing to the inside surface of the cap 240 at the front wall 240a. In step 530, the thermal interface material is embedded in the pores of the porous metal foam material. This may be accomplished, for example, by dispensing or stencil printing. In step 540, the cap with the attached compliant heat spreader 244 formed by the porous metal foam material with embedded thermal interface material is mounted to the substrate to cover the flip chip mounted integrated circuit die.

While the invention has been illustrated and described in detail in the drawings and foregoing description, such illustration and description are considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims.

Example embodiments of the present disclosure are summarized here. Other embodiments can also be understood from the entirety of the specification and the examples.

Example 1 : An integrated circuit package, comprising:
- a substrate having a front surface with front connection pads;
- an integrated circuit die having a front surface and rear surface with die connection pads at the front surface;
wherein the integrated circuit die is mounted to the substrate in a flip chip orientation with the front surface of the integrated circuit die facing the front surface of the substrate;
- electrical connections between the die connection pads and the front connection pads;
- a thermally conductive cap mounted to the substrate to enclose the integrated circuit die; and
- a compliant heat spreader positioned between the rear surface of the integrated circuit die and an inside surface of the thermally conductive cap, wherein the compliant heat spreader comprises a porous metal foam material layer with a thermal interface material contained within pores of the porous metal foam material layer.

Example 2 : The integrated circuit package of example 1, wherein the porous metal foam material layer is made of a Copper material.

Example 3 : The integrated circuit package of example 1 or 2, wherein the porous metal foam material layer is brazed to the inside surface of the thermally conductive cap.

Example 4 : The integrated circuit package of any of examples 1 to 3, wherein the porous metal foam material layer is welded to the inside surface of the thermally conductive cap.

Example 5 : The integrated circuit package of any of examples 1 to 4, wherein the inside surface of the thermally conductive cap includes a recess and the porous metal foam material layer is mounted within the recess.

Example 6 : The integrated circuit package of any of examples 1 to 5, wherein the porous metal foam material layer is in contact with both the inside surface of the thermally conductive cap and the rear surface of the integrated circuit die.

Example 7 : The integrated circuit package of any of examples 1 to 6, wherein the thermally conductive cap includes a front wall and a peripheral wall; wherein a distal end of the peripheral wall is mounted to the substrate; and wherein the porous metal foam material layer completely covers the inside surface of the thermally conductive cap at the front wall.

Example 8 : The integrated circuit package of any of examples 1 to 7, wherein the thermal interface material fills the pores of the porous metal foam material layer to a level in excess of 90%.

Example 9 : The integrated circuit package of any of examples 1 to 8, wherein the thermally conductive cap includes heat spreading fins.

Example 10 : The integrated circuit package of any of examples 1 to 9, wherein a rear surface of the substrate includes rear connection pads and the substrate further includes an electrical connection network configured to electrically connect the front connection pads of the substrate to the rear connection pads of the substrate.

Example 11 : The integrated circuit package of any of examples 1 to 9, wherein the compliant heat spreader has an effective thermal conductivity in excess of 10 W/m-K.

Example 12 : The integrated circuit package of any of examples 1 to 11, wherein a porosity of the porous metal foam material layer is greater than or equal to 80%.

Example 13 : The integrated circuit package of any of examples 1 to 12, wherein a modulus of the porous metal foam material layer is less than or equal to 40 GPa.

Example 14 : A method of making an integrated circuit package, comprising:
- mounting an integrated circuit die in flip chip orientation to a substrate;
- mounting a porous metal foam material layer to an inside surface of a thermally conductive cap;
- placing a thermal interface material within pores of the porous metal foam material layer; and
- attaching the thermally conductive cap to the substrate to enclose the integrated circuit die with porous metal foam material layer positioned in contact with a back surface of the integrated circuit die.

Example 15 : The method of example 14, wherein mounting the porous metal foam material layer comprises brazing the porous metal foam material layer to the inside surface of the thermally conductive cap.

Example 16 : The method of example 14 or 15, wherein mounting the porous metal foam material layer comprises diffusion welding the porous metal foam material layer to the inside surface of the thermally conductive cap.

Example 17 : The method of any of examples 14 to 16, wherein placing the thermal interface material within pores of the porous metal foam material layer comprises dispensing the thermal interface material.

Example 18 : The method of any of examples 14 to 17, wherein placing the thermal interface material within pores of the porous metal foam material layer comprises stencil printing the thermal interface material.

## Claims

1. An integrated circuit package, comprising:
- a substrate having a front surface with front connection pads;
- an integrated circuit die having a front surface and rear surface with die connection pads at the front surface;
wherein the integrated circuit die is mounted to the substrate in a flip chip orientation with the front surface of the integrated circuit die facing the front surface of the substrate;
- electrical connections between the die connection pads and the front connection pads;
- a thermally conductive cap mounted to the substrate to enclose the integrated circuit die; and
- a compliant heat spreader positioned between the rear surface of the integrated circuit die and an inside surface of the thermally conductive cap, wherein the compliant heat spreader comprises a porous metal foam material layer with a thermal interface material contained within pores of the porous metal foam material layer.

2. A method of making an integrated circuit package, comprising:
- mounting an integrated circuit die in flip chip orientation to a substrate;
- mounting a porous metal foam material layer to an inside surface of a thermally conductive cap;
- placing a thermal interface material within pores of the porous metal foam material layer; and
- attaching the thermally conductive cap to the substrate to enclose the integrated circuit die with porous metal foam material layer positioned in contact with a back surface of the integrated circuit die.

3. The integrated circuit package of claim 1, wherein the porous metal foam material layer is made of a Copper material.

4. The integrated circuit package of claim 1 or 3, wherein the porous metal foam material layer is brazed, or the method of claim 2 wherein mounting the porous metal foam material layer comprises brazing the porous metal foam material layer, to the inside surface of the thermally conductive cap.

5. The integrated circuit package of any of claims 1, 3 or 4, wherein the porous metal foam material layer is welded, or the method of claim 2 or 4 wherein mounting the porous metal foam material layer comprises diffusion welding the porous metal foam material layer, to the inside surface of the thermally conductive cap.

6. The integrated circuit package of any of claims 1, 3 to 5, wherein the inside surface of the thermally conductive cap includes a recess and the porous metal foam material layer is mounted within the recess.

7. The integrated circuit package of any of claims 1, 3 to 6, wherein the porous metal foam material layer is in contact with both the inside surface of the thermally conductive cap and the rear surface of the integrated circuit die.

8. The integrated circuit package of any of claims 1, 3 to 7, wherein the thermally conductive cap includes a front wall and a peripheral wall; wherein a distal end of the peripheral wall is mounted to the substrate; and wherein the porous metal foam material layer completely covers the inside surface of the thermally conductive cap at the front wall.

9. The integrated circuit package of any of claims 1, 3 to 8, wherein the thermal interface material fills the pores of the porous metal foam material layer to a level in excess of 90%.

10. The integrated circuit package of any of claims 1, 3 to 9, wherein the thermally conductive cap includes heat spreading fins.

11. The integrated circuit package of any of claims 1, 3 to 10, wherein a rear surface of the substrate includes rear connection pads and the substrate further includes an electrical connection network configured to electrically connect the front connection pads of the substrate to the rear connection pads of the substrate.

12. The integrated circuit package of any of claims 1, 3 to 11, wherein the compliant heat spreader has an effective thermal conductivity in excess of 10 W/m-K.

13. The integrated circuit package of any of claims 1, 3 to 12, wherein a porosity of the porous metal foam material layer is greater than or equal to 80%.

14. The integrated circuit package of any of claims 1, 3 to 13, wherein a modulus of the porous metal foam material layer is less than or equal to 40 GPa.

15. The method of any of claims 2, 4 or 5, wherein placing the thermal interface material within pores of the porous metal foam material layer comprises dispensing the thermal interface material,
and/or
wherein placing the thermal interface material within pores of the porous metal foam material layer comprises stencil printing the thermal interface material.
